(19) Europäisches Patentamt / European Patent Office / Office européen des brevets

(11) **EP 4 037 335 B1**

(12) **EUROPEAN PATENT SPECIFICATION**

(45) Date of publication and mention
of the grant of the patent:
**25.03.2026 Bulletin 2026/13**

(21) Application number: **20881753.6**

(22) Date of filing: **14.09.2020**

(51) International Patent Classification (IPC):
*H04R 19/04* (2006.01)    *H04R 31/00* (2006.01)
*H04R 17/02* (2006.01)

(52) Cooperative Patent Classification (CPC):
**H04R 17/02; H04R 19/04;** H04R 31/006;
H04R 2201/003

(86) International application number:
**PCT/CN2020/115104**

(87) International publication number:
**WO 2021/082764 (06.05.2021 Gazette 2021/18)**

(54) **PIEZOELECTRIC MEMS SENSOR AND RELEVANT DEVICE**

PIEZOELEKTRISCHER MEMS-SENSOR UND ENTSPRECHENDE VORRICHTUNG

CAPTEUR MEMS PIÉZOÉLECTRIQUE ET DISPOSITIF APPROPRIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.10.2019 CN 201911053981**

(43) Date of publication of application:
**03.08.2022 Bulletin 2022/31**

(73) Proprietor: HUAWEI TECHNOLOGIES CO., LTD.
**Shenzhen, Guangdong 518129 (CN)**

(72) Inventors:
 • **YAO, Danyang**
   **Shenzhen, Guangdong 518129 (CN)**
 • **XU, Jinghui**
   **Shenzhen, Guangdong 518129 (CN)**

(74) Representative: **Goddar, Heinz J.**
   **Boehmert & Boehmert**
   **Anwaltspartnerschaft mbB**
   **Pettenkoferstrasse 22**
   **80336 München (DE)**

(56) References cited:
   WO-A1-2017/049278     WO-A1-2018/035486
   WO-A1-2018/050551     CN-A- 103 460 721
   CN-A- 103 460 721     CN-A- 109 587 612
   US-A1- 2018 186 623

**Description**

**TECHNICAL FIELD**

This application relates to the field of acoustic-electric technologies, and in particular, to a piezoelectric MEMS sensor and a related device.

**BACKGROUND**

A piezoelectric microelectromechanical system (MEMS) sensor is increasingly widely used because the piezoelectric MEMS sensor has a good dustproof advantage, a waterproof advantage, or the like.

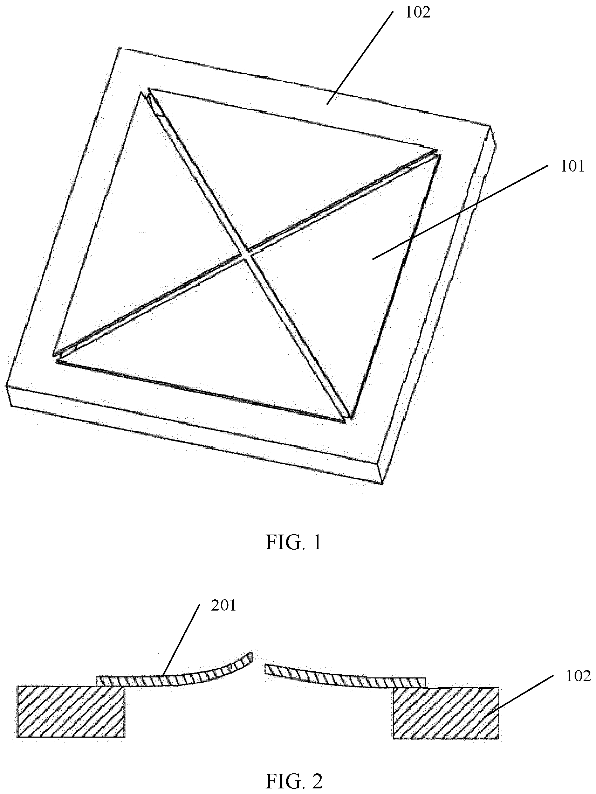

The following describes a structure of an existing piezoelectric MEMS sensor with reference to FIG. 1. As shown in FIG. 1, the piezoelectric MEMS sensor includes a plurality of diaphragms 101, one end of each diaphragm 101 is connected to a substrate 102, and a cantilever structure is used at the other end. As shown in FIG. 2, a cantilever structure 201 bends upwards under sound pressure, to form a stress difference between an upper surface and a lower surface of the cantilever structure 201, and further generate a voltage.

However, stress generated by the diaphragm 101 under the sound pressure is unevenly distributed, greatly affecting performance of the piezoelectric MEMS sensor, for example, causing low sensitivity of the piezoelectric MEMS sensor or a low signal-to-noise ratio of the piezoelectric MEMS sensor.

CN 109 587 612 A describes a piezoelectric microphone, and it includes a substrate having a back cavity and a piezoelectric cantilever diaphragm fixed to the substrate. The piezoelectric cantilever diaphragm includes a plurality of diaphragm flaps, and each of the diaphragm flaps has one end fixed to the substrate and another end suspended above the back cavity. Every two adjacent ones of the diaphragm flaps are spaced apart to form a gap. The piezoelectric microphone further comprises an elastically stretchable member connecting the two adjacent diaphragm flaps, and the elastically stretchable member is provided between at least one set of two adjacent ones of the diaphragm flaps. WO 2018/035486 A1 describes a piezoelectric, acoustic device comprising: a substrate; a plurality of plates, each plate comprising a first electrode layer, a piezoelectric layer and a second electrode layer, wherein the piezoelectric layer is in between the first electrode layer and the second electrode layer, and wherein, for each plate, a base of the plate is affixed to the substrate and a remaining portion of the plate is unaffixed to the substrate; and a plate coupling structure affixed to a first one of the plates and to a second one of the plates, wherein the plate coupling structure at least partly covers a gap between a first edge of the first one of the plates and a second edge of the second one of the plates, wherein the first edge faces the second edge; wherein the plate coupling structure comprises a mismatch reduction element and a stopping element, wherein the mismatch reduction element is configured to reduce an amount of mismatch in deflection of the first one of the plates and the second one of the plates, and wherein the stopping element is configured to enable the mismatch reduction element to expand only up to a specified amount.

CN 103 460 721 A describes a transducer with a plurality of adjacent, tapered cantilevered beams. Each of the beams define a beam base, a beam tip, and a beam body disposed between the beam base and the beam tip. The beams are arranged such that each of the beam tips extends toward a common area. Each beam is joined to the substrate along the beam base and is free from the substrate along the beam body.

**SUMMARY**

The invention is defined by the independent claims. Advantageous embodiments of the invention are given by the dependent claims. The present invention provides a piezoelectric MEMS sensor and a related device, to resolve problems of a low signal-to-noise ratio and low sensitivity of an existing piezoelectric MEMS sensor.

The present invention provides a piezoelectric MEMS sensor, including a substrate and at least one cantilever. The substrate includes a sound entry channel. The cantilever includes a first region and a second region that are connected to each other, the second region is suspended over a channel port of the sound entry channel, the first region is located between the second region and the substrate, an area of the second region gradually decreases in a direction away from the first region, the cantilever is configured to obtain a corresponding voltage under an action of a sound signal, and the sound signal is transmitted through the sound entry channel. The first region includes a first side face and a second side face connected to the first side face, the first side face is a side face that is of the first region and that faces a target face, the target face is a face that is of the cantilever and that is connected to the substrate, and an included angle between the first side face and the second side face is greater than or equal to 90 degrees and less than 180 degrees.

In a structure of the cantilever, because the included angle between the first side face and the second side face is any angle greater than or equal to 90 degrees and less than 180 degrees, there are fewer restrictions on two sides of the first region of the cantilever, and two sides of the cantilever are not constrained by another structure, to effectively ensure free deformation of the cantilever, help improve evenness of a stress distribution on the cantilever, and effectively improve a signal-to-noise ratio and sensitivity.

With reference to the first aspect of embodiments of the present invention, in an optional implementation of the first aspect of embodiments of the present invention, along a radial direction of the sound entry channel, the first region is of a quadrate structure, and the second region is of a triangular structure.

In a structure of the cantilever shown in this aspect, when the second region is triangular, a quantity of disposed cantilevers may be increased as much as possible when the sound entry channel of the piezoelectric MEMS sensor has a limited area, to improve utilization efficiency of the sound entry channel, and improve sensitivity of the piezoelectric MEMS sensor.

With reference to the first aspect of embodiments of the present invention, in an optional implementation of the first aspect of embodiments of the present invention, along a radial direction of the sound entry channel, the first region is of a trapezoidal structure, the second region is of a triangular structure, and the included angle between the first side face and the second side face is greater than 90 degrees and less than 180 degrees.

In a structure of the cantilever shown in this aspect, a degree of freedom of the first region of the trapezoidal structure is further increased, to further improve a stress distribution in the first region of the cantilever, effectively improve evenness of the stress distribution in the first region, and improve sensitivity and a signal-to-noise ratio of the piezoelectric MEMS sensor.

With reference to the first aspect of embodiments of the present invention, in an optional implementation of the first aspect of embodiments of the present invention, the cantilever further includes a first electrode and a second electrode; and the first region includes a piezoelectric thin film unit; and along an axial direction of the sound entry channel, the piezoelectric thin film unit includes a first surface and a second surface that are opposite to each other, the first electrode is located on the first surface, the second electrode is located on the second surface, the first electrode and the second electrode are configured to obtain the voltage, and the piezoelectric thin film unit includes at least one layer of piezoelectric thin film.

With reference to the first aspect of embodiments of the present invention, in an optional implementation of the first aspect of embodiments of the present invention, the piezoelectric thin film unit wraps a third electrode, and the third electrode is located between the first electrode and the second electrode along the axial direction of the sound entry channel.

To obtain the voltage generated by the cantilever under the action of the sound signal, a stress difference needs to be formed between the first surface and the second surface of the cantilever, and the first electrode and the second electrode may obtain the voltage based on the stress difference. When the piezoelectric thin film unit wraps the third electrode, obtaining of the voltage is effectively ensured, to avoid a case in which the voltage cannot be detected due to a very small stress difference formed between the first surface and the second surface.

With reference to the first aspect of embodiments of the present invention, in an optional implementation of the first aspect of embodiments of the present invention, the cantilever further includes a support layer, the support layer is disposed by being attached to a surface that is of the piezoelectric thin film unit and that faces the sound entry channel, and an end portion of the support layer is connected to the substrate.

When the cantilever is deformed, a part of deformation of the second surface of the cantilever is counteracted under a withstanding action of the support layer, to form a stress difference between stress generated on the first surface of the cantilever and stress generated on the second surface. The first electrode and the second electrode may obtain the voltage based on the stress difference.

With reference to the first aspect of embodiments of the present invention, in an optional implementation of the first aspect of embodiments of the present invention, the piezoelectric thin film unit is connected to the substrate, and the first side face of the cantilever is a side face on which the piezoelectric thin film unit is connected to the substrate.

The piezoelectric thin film unit and the support layer of the cantilever in this manner are both connected to the substrate, to effectively improve stability of a structure of the piezoelectric MEMS sensor.

With reference to the first aspect of embodiments of the present invention, in an optional implementation of the first aspect of embodiments of the present invention, there is a gap between the piezoelectric thin film unit and the substrate, and a first side face of the cantilever is a side face that is of the piezoelectric thin film unit and that faces the target face.

When there is a gap between the piezoelectric thin film unit and the substrate, the cantilever is connected to the substrate by using the support layer, so that rigidity of an end portion that is of the cantilever and that is connected to the substrate is reduced. Therefore, there is a smaller device dimension in a case of a same frequency, to help miniaturize the piezoelectric MEMS sensor.

With reference to the first aspect of embodiments of the present invention, in an optional implementation of the first aspect of embodiments of the present invention, along the radial direction of the sound entry channel, an area of the first region is less than or equal to 50% of an area of the cantilever.

When an area of a first cross section is less than or equal to 50% of an area of a second cross section, a signal-to-noise ratio and sensitivity of the cantilever provided in embodiments can be effectively improved.

With reference to the first aspect of embodiments of the present invention, in an optional implementation of the first aspect of embodiments of the present invention, the piezoelectric MEMS sensor includes four cantilevers, and there is a gap between any two adjacent cantilevers.

According to this aspect, a structure in which the four cantilevers are disposed is used, to effectively increase a proportion of the cantilever to a surface of the piezoelectric MEMS sensor, and effectively improve utilization efficiency of the piezoelectric MEMS sensor. Because there is a gap between any two adjacent cantilevers, it is effectively ensured that any cantilever can be freely deformed under the action of the sound signal, and there is no interference from another cantilever in a deformation process, to improve efficiency of converting the sound signal into a voltage.

With reference to the first aspect of embodiments of the present invention, in an optional implementation of the first aspect of embodiments of the present invention, the first region includes two second side faces.

According to this aspect, the included angle between the two second side faces of the first region is greater than or equal to 90 degrees and less than 180 degrees. In this case, a signal-to-noise ratio and sensitivity of the cantilever are effectively improved.

A second aspect of embodiments of the present invention provides a piezoelectric MEMS microphone, including a piezoelectric MEMS sensor and an amplification circuit. The piezoelectric MEMS sensor and the amplification circuit are electrically connected, the piezoelectric MEMS sensor is configured to obtain a voltage under an action of a sound signal, the amplification circuit is configured to obtain and amplify the voltage, and the piezoelectric MEMS sensor is shown in any one of the foregoing implementations.

A third aspect of embodiments of the present invention provides a piezoelectric MEMS microphone array. The piezoelectric MEMS microphone array includes a plurality of piezoelectric MEMS microphones shown in the second aspect.

Based on the third aspect of embodiments of the present invention, in an optional implementation of the third aspect of embodiments of the present invention, the plurality of piezoelectric MEMS microphones are connected to an audio circuit in series, and the audio circuit is configured to obtain and process a voltage from the piezoelectric MEMS microphone, to effectively reduce difficulty in obtaining and processing the voltage from the piezoelectric MEMS microphone by the audio circuit.

Based on the third aspect of embodiments of the present invention, in an optional implementation of the third aspect of embodiments of the present invention, the plurality of piezoelectric MEMS microphones are connected to the audio circuit in parallel, to effectively increase a value of output capacitance of the piezoelectric MEMS microphone.

A fourth aspect of embodiments of the present invention provides a terminal device, including an audio system. The audio system includes one or more piezoelectric MEMS microphones, and an audio circuit electrically connected to the piezoelectric MEMS microphone, and the piezoelectric MEMS microphone is shown in the second aspect.

Based on the fourth aspect of embodiments of the present invention, in an optional implementation of the fourth aspect of embodiments of the present invention, the audio circuit is electrically connected to a speaker or a processor.

## BRIEF DESCRIPTION OF DRAWINGS

FIG. 1 is an example diagram of a top-view structure of an existing piezoelectric MEMS sensor;
FIG. 2 is an example diagram of a side-view structure of an existing piezoelectric MEMS sensor;
FIG. 3 is an example diagram of a structure in an embodiment of an audio system according to the present invention;
FIG. 4 is an example diagram of a top-view structure in an embodiment of a piezoelectric MEMS microphone according to the present invention;
FIG. 5 is an example diagram of a side-view cross-sectional structure in an embodiment of a piezoelectric MEMS microphone according to the present invention;
FIG. 6 is an example diagram of a side-view cross-sectional structure in another embodiment of a piezoelectric MEMS sensor according to the present invention;
FIG. 7 is an example diagram of a side-view cross-sectional structure in another embodiment of a piezoelectric MEMS sensor according to the present invention;
FIG. 8a is an example diagram of an application scenario of a cantilever on which no sound signal acts according to the present invention;
FIG. 8b is an example diagram of an application scenario of a cantilever on which a sound signal acts according to the present invention;
FIG. 9 is an example diagram of a top-view structure in an embodiment of a piezoelectric MEMS sensor according to the present invention;
FIG. 10 is an example diagram of an entire structure in an embodiment of a piezoelectric MEMS sensor according to the present invention;

FIG. 11 is an example diagram of a structure in which an included angle between a first side face and a second side face is an acute angle;

FIG. 12 is a diagram of a simulation of a stress distribution in a structure in which an included angle between a first side face and a second side face is an acute angle;

FIG. 13 is a diagram of a simulation of a stress distribution in a first region of a cantilever under an action of a sound signal according to the present invention;

FIG. 14 is an example diagram of a performance comparison between a cantilever provided with a low stress region and a cantilever provided with no low stress region;

FIG. 15 is an example diagram of a top-view structure in another embodiment of a piezoelectric MEMS sensor according to the present invention;

FIG. 16 is an example diagram of an entire structure in an embodiment of a piezoelectric MEMS sensor according to the present invention;

FIG. 17 is an example diagram of a side-view cross-sectional structure in another embodiment of a piezoelectric MEMS sensor according to the present invention;

FIG. 18 is an example diagram of a side-view cross-sectional structure in another embodiment of a piezoelectric MEMS sensor according to the present invention;

FIG. 19 is an example diagram of a side-view cross-sectional structure in another embodiment of a piezoelectric MEMS sensor according to the present invention;

FIG. 20 is an example diagram of a side-view cross-sectional structure in another embodiment of a piezoelectric MEMS sensor according to the present invention; and

FIG. 21 is a block diagram of a structure in an embodiment of a terminal device according to the present invention.

## DESCRIPTION OF EMBODIMENTS

The following clearly and completely describes the technical solutions in embodiments of the present invention with reference to the accompanying drawings in embodiments of the present invention. It is clear that the described embodiments are merely some but not all of embodiments of the present invention.

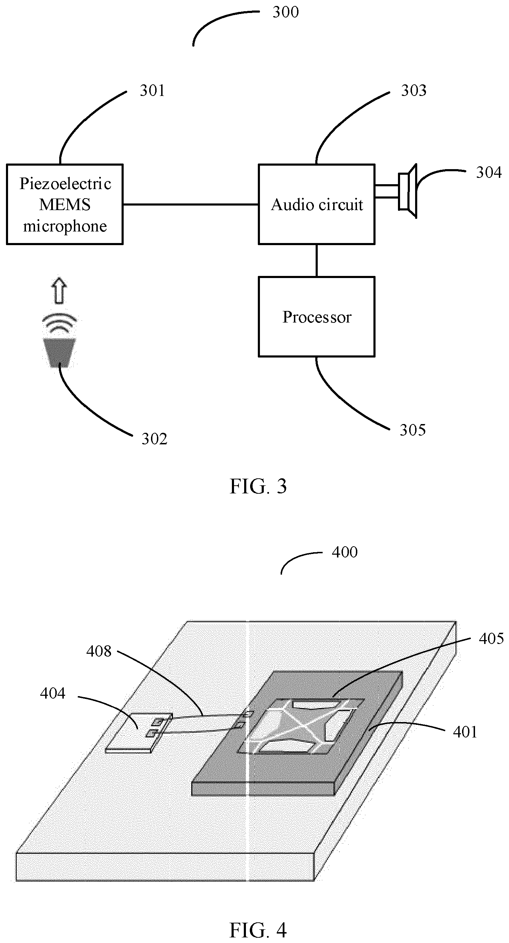

A structure of an audio system provided in an embodiment is described below with reference to FIG. 3 by using an example.

An audio system 300 in this embodiment may be applied to a terminal device. The terminal device may be a cellular phone, a cordless phone, a session initiation protocol (SIP) phone, a personal digital assistant (PDA), a handheld device with a wireless communication function, a computing device, a vehicle-mounted device, a wearable device, a wired or wireless headset, a terminal device in smart home, a microphone array, a terminal device in a 5th generation mobile communication technology (5G), a terminal device in a future evolved public land mobile network (PLMN), or the like. This is not limited in this application.

As shown in FIG. 3, the audio system 300 shown in this embodiment includes a piezoelectric MEMS microphone 301 and an audio circuit 303 that are electrically connected in sequence.

The piezoelectric MEMS microphone 301 is configured to sense a sound signal 302, and the piezoelectric MEMS microphone 301 is configured to restore a human voice or an ambient sound, so that the audio system 300 completes collection of a sound. A microelectromechanical system (MEMS) is a high-tech apparatus that is several millimeters or even smaller in size, an internal structure of the microelectromechanical system is usually at a micrometer level or even at a nanometer level, and the microelectromechanical system is an independent intelligent system. There is a smaller microphone and higher performance because of a MEMS technology. The MEMS microphone has many advantages such as a high signal-to-noise ratio, low power consumption, high sensitivity, an advantage that a micro-package is compatible with a mounting process, an advantage that reflow soldering exerts no impact on performance of the MEMS microphone, and an excellent temperature characteristic.

Specifically, a cantilever of the piezoelectric MEMS microphone 301 is configured to obtain a voltage based on the sound signal 302. The piezoelectric MEMS microphone 301 sends the obtained voltage to the audio circuit 303, and the audio circuit 303 may process the received voltage.

The audio circuit 303 may process the received voltage in the following manner:

For example, the audio circuit 303 in this embodiment is further connected to a speaker 304. The audio circuit 303 may convert the received voltage into an electrical signal, and transmit the electrical signal to the speaker 304. The speaker 304 converts the electrical signal into a sound signal for output. For another example, the audio circuit 303 is further connected to a processor 305. The audio circuit 303 may convert the received voltage into audio data, and then transmit the audio data to the processor 305. The processor 305 performs corresponding processing on the audio data.

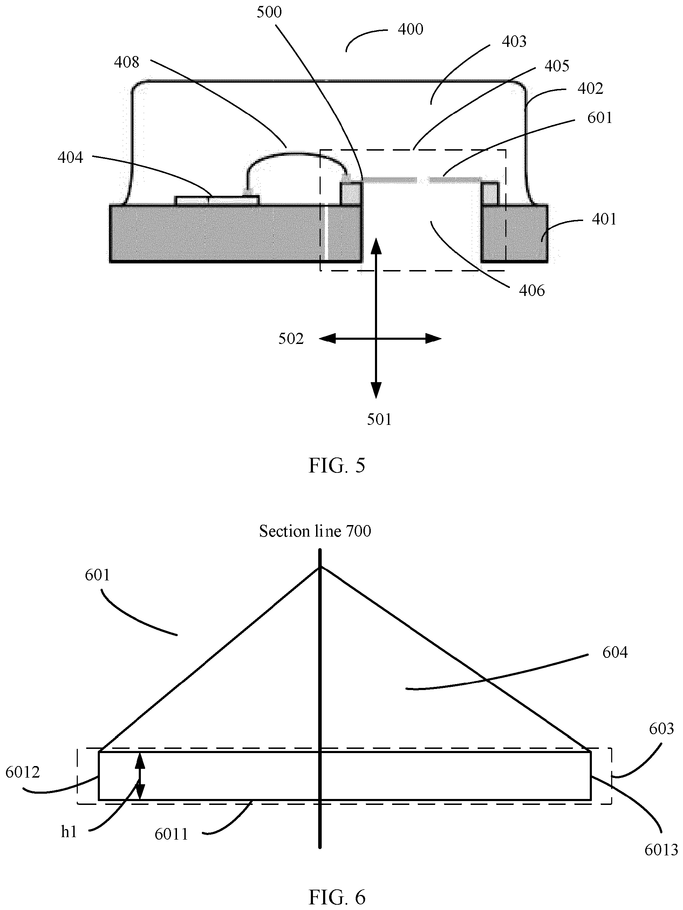

The following provides an example description of a specific structure of a piezoelectric MEMS microphone with reference to FIG. 4 and FIG. 5. FIG. 4 is an example diagram of a top-view structure in an embodiment of a piezoelectric MEMS microphone. FIG. 5 is an example diagram of a side-view cross-sectional structure in an embodiment of a piezoelectric MEMS microphone.

With reference to FIG. 4 and FIG. 5, it can be learned that a piezoelectric MEMS microphone 400 in this embodiment includes a substrate 401 and a housing 402. The substrate 401 may be a printed circuit board (PCB), or may be a ceramic plate. This is not specifically limited in this embodiment. A sound chamber 403 is formed between the substrate 401 and the housing 402 that are connected through snap-fitting. The sound chamber 403 includes an amplification circuit 404 and a piezoelectric MEMS sensor 405.

The substrate 401 includes a sound entry channel 406. Optionally, an orthogonal projection shape of the sound entry channel 406 may be a circle, an ellipse, a quadrate, a polygon, or the like. In this embodiment, that the orthogonal projection shape of the sound entry channel 406 is a quadrate is used as an example for an example description. A sound signal may be transmitted through the sound entry channel 406, to act on the piezoelectric MEMS sensor 405.

When the piezoelectric MEMS sensor 405 correspondingly generates a voltage based on the sound signal, the voltage generated by the piezoelectric MEMS sensor 405 is weak and cannot be directly used by the audio circuit. Therefore, the piezoelectric MEMS microphone 400 further includes an amplification circuit 404 for amplifying the voltage from the piezoelectric MEMS sensor 405.

The piezoelectric MEMS sensor 405 and the amplification circuit 404 may be electrically connected through a conducting wire 408, and the amplification circuit 404 is configured to amplify the voltage from the piezoelectric MEMS sensor 405. Optionally, the amplification circuit 404 may be an application-specific integrated circuit (ASIC). The amplification circuit 404 sends the amplified voltage to the audio circuit, and the audio circuit may process the received amplified voltage.

Based on the foregoing description of a structure of the piezoelectric MEMS microphone, the following provides an example description of a specific structure of the piezoelectric MEMS sensor provided in this application.

A specific structure of the piezoelectric MEMS sensor provided in this embodiment is first described with reference to FIG. 5 and FIG. 6. The piezoelectric MEMS sensor in this embodiment further includes a cantilever 601, and the cantilever 601 includes a first region 603 and a second region 604 that are connected to each other. The second region 604 of the cantilever 601 is suspended over a channel port of the sound entry channel 406, and when the sound signal acts on the cantilever 601, the second region 604 of the cantilever 601 can be deformed freely. The first region 603 of the cantilever 601 is located between the substrate 401 and the second region 604.

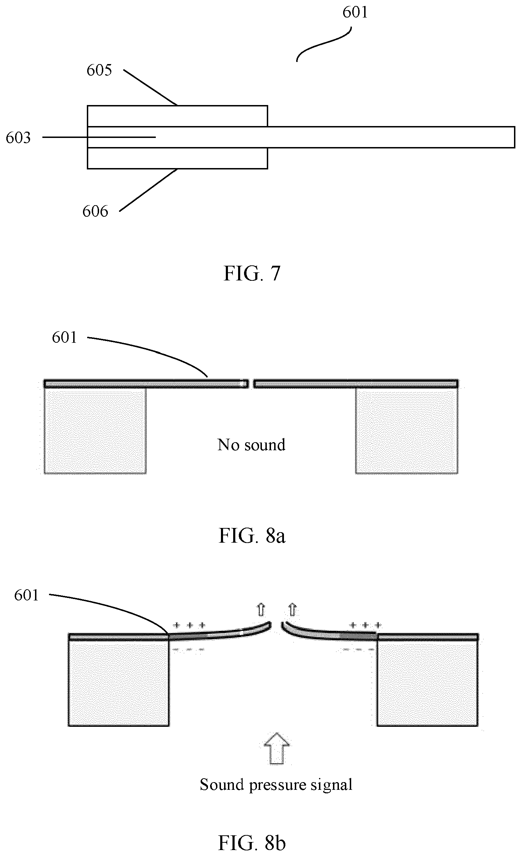

For details, continue to refer to FIG. 7. FIG. 7 is an example diagram of a cross-sectional structure formed by sectioning the cantilever in FIG. 6 along a section line 700. As shown in FIG. 7, the first region 603 of the cantilever 601 includes a first surface and a second surface that are opposite to each other along an axial direction of the sound entry channel 406 (a direction indicated by an arrow 501 in FIG. 5). The cantilever 601 further includes a first electrode 605 and a second electrode 606 for voltage collection. The first surface is attached to the first electrode 605, and the second surface is attached to the second electrode 606.

It should be noted that, in this embodiment. a value relationship between an area of the first region 603, an area of the first electrode 605, and an area of the second electrode 606 is not limited. For example, the area of the first electrode 605 and the area of the second electrode 606 may be equal, and the area of the first electrode 605 may be equal to the area of the first region 603. For another example, the area of the first electrode 605 and the area of the second electrode 606 may be smaller than the area of the first region 603. For another example, the area of the first electrode 605 and the area of the second electrode 606 may alternatively be greater than the area of the first region 603.

Specifically, the following provides an example description of a specific process in which the cantilever 601 generates the voltage based on the sound signal in this embodiment.

As shown in FIG. 8a, if no sound signal acts on the cantilever 601, the cantilever 601 is not deformed. In this case, the cantilever 601 does not generate a voltage.

As shown in FIG. 8b, when a sound signal acts on the cantilever 601, the sound signal enables the cantilever 601 to vibrate, to deform the cantilever 601. For the deformed cantilever 601, a stress difference is formed between stress formed on an upper surface and stress formed on a lower surface of the cantilever 601.

When a stress difference is formed between the upper surface and the lower surface of the cantilever 601, an electric potential difference, namely, a voltage, is generated between the first electrode 605 and the second electrode 606. In this case, the cantilever 601 obtains the voltage by using the first electrode 605 and the second electrode 606 located on the two surfaces of the first region 603.

The following describes how to improve utilization efficiency of the piezoelectric MEMS sensor.

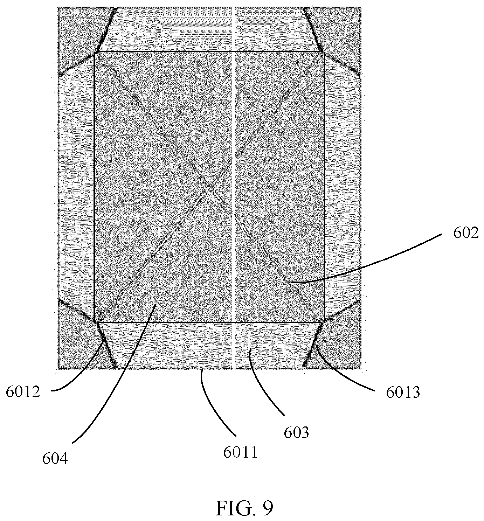

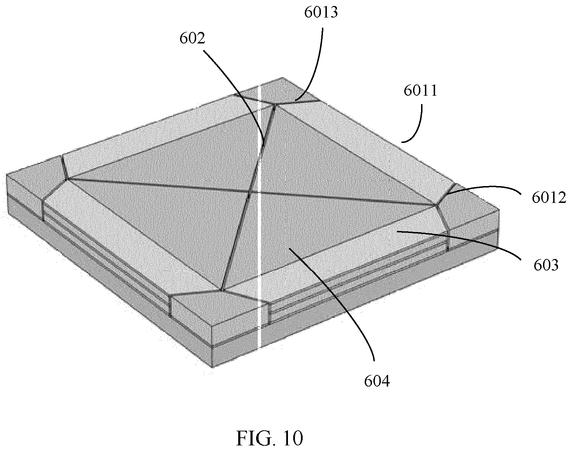

The piezoelectric MEMS sensor in this embodiment may include one or more cantilevers 601. To improve utilization efficiency of the piezoelectric MEMS sensor, a structure of the piezoelectric MEMS sensor is further described with reference to FIG. 9 and FIG. 10. The piezoelectric MEMS sensor may include a plurality of cantilevers 601. For example, the piezoelectric MEMS sensor includes four cantilevers 601, and an area of each second region 604 gradually increases in a direction close to the first region 603. In other words, the area of each second region 604 gradually decreases in a direction away from the first region 603. Therefore, a coverage area of a second region 604 of each cantilever 601 at the channel port of the sound entry channel 406 is improved, and utilization efficiency of a chip of the piezoelectric MEMS sensor is effectively improved.

It should be noted that, in this embodiment, a specific quantity of cantilevers 601 included in the piezoelectric MEMS sensor is not limited. It only needs to be ensured that a proportion of the cantilever 601 is as large as possible on a surface of the piezoelectric MEMS sensor. If each cantilever 601 is successfully deformed based on an action of the sound signal, there is a gap 602 between any two adjacent cantilevers 601 included in the piezoelectric MEMS sensor. Therefore, in a process in which any cantilever 601 is deformed under the action of the sound signal, there is no interference from another cantilever 601, to improve efficiency of converting the sound signal into a voltage.

Continue to refer to FIG. 6, FIG. 9, and FIG. 10. The first region 603 of the cantilever 601 includes a first side face 6011 and a second side face 6012 connected to the first side face 6011. Specifically, the first side face 6011 is a side face that is of the first region 603 and that faces a target face. For the target face, as shown in FIG. 5, a target face 500 is a face that is of the cantilever 601 and that is connected to the substrate 401.

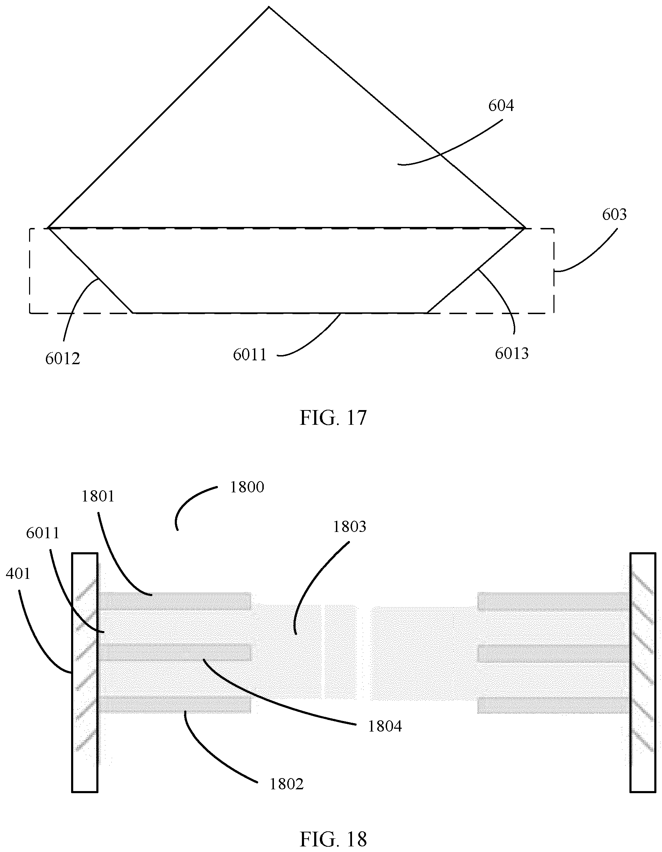

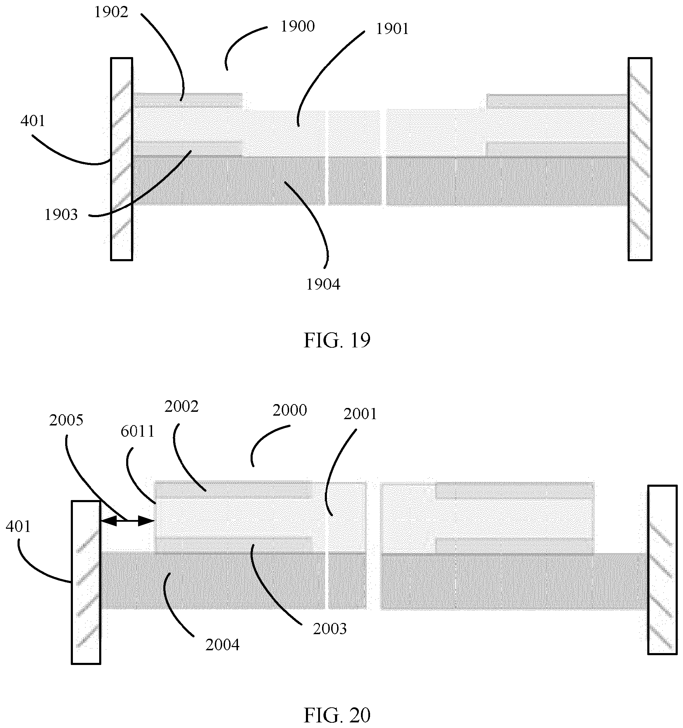

The first side face 6011 is a side face that is of the first region 603 and that faces the target face 500. Specifically, a gap between the first side face 6011 and the substrate 401 is less than a gap between another side face of the first region 603 and the substrate 401. As shown in FIG. 18, the first region 603 is connected to the substrate 401, and a gap between the first side face 6011 and the substrate 401 is 0. Optionally, as shown in FIG. 20, there is a gap between the first region 603 and the substrate 401, and the first side face 6011 is a side face that is separated from the substrate 401 by a gap 2005.

To improve a signal-to-noise ratio (SNR) of the piezoelectric MEMS sensor, an included angle between the first side face 6011 and the second side face connected to the first side face 6011 is greater than or equal to 90 degrees and less than 180 degrees. In addition, the included angle between the first side face 6011 and the second side face in this embodiment faces the second region 604. The second side face may be the second side face 6012 or a second side face 6013 in FIG. 6, FIG. 9, and FIG. 10. Optionally, an included angle between the first side face 6011 and the second side face 6012 and an included angle between the first side face 6011 and the second side face 6013 each are greater than or equal to 90 degrees and less than 180 degrees. In this embodiment, a specific value of the included angle between the first side face 6011 and the second side face (6012 and/or 6013) is not limited. It only needs to be ensured that the included angle between the first side face 6011 and the second side face is of a right-angle structure or an obtuse-angle structure. For example, as shown in FIG. 6, the included angle between the first side face 6011 and the second side face is a right angle. For another example, as shown in FIG. 9 and FIG. 10, the included angle between the first side face 6011 and the second side face is an obtuse angle. When the included angle between the first side face 6011 and the second side face in this embodiment is of a right-angle structure or an obtuse-angle structure, a signal-to-noise ratio of the piezoelectric MEMS sensor can be effectively improved.

The following first describes a reason why the signal-to-noise ratio of the piezoelectric MEMS sensor is important:

The signal-to-noise ratio is an important acoustic parameter of the piezoelectric MEMS sensor, and the SNR is a ratio of a signal received by the piezoelectric MEMS sensor to noise. When a sound pressure level (SPL) of a sound source and a maximum value of a voltage that can be obtained by the piezoelectric MEMS sensor through conversion are fixed, a piezoelectric MEMS sensor with a high SNR may extract, at a farther location, a sound signal emitted by the sound source. It can be learned that the piezoelectric MEMS sensor with a high SNR has better performance in converting a sound signal into a voltage.

However, when a quantity of charges generated by the cantilever 601 under the action of the sound signal is effectively improved, the SNR of the piezoelectric MEMS sensor can be effectively improved. A specific description is provided below.

Specifically, the signal-to-noise ratio of the piezoelectric MEMS sensor may be evaluated based on a formula

$$SNR = \frac{Q}{\sqrt{C}} \times \sqrt{\frac{\omega}{4k_b T \tan \delta}}$$ . In the formula, Q is the quantity of charges generated by the cantilever under the action of the sound signal, C is a capacitance value of an electrode region, the electrode region is a region including the first electrode and the second electrode, $\omega$ is a frequency of the sound source, $k_b$ is a Boltzmann constant, T is a temperature, tan$\delta$ is a dielectric loss angle of a piezoelectric material, and the piezoelectric material is a material used to make the cantilever 601. Herein, $\sqrt{\frac{\omega}{4k_b T \tan \delta}}$ may be considered as a constant for a specified piezoelectric MEMS sensor, but $\frac{Q}{\sqrt{C}}$ is related to the structure of the piezoelectric MEMS sensor. An evaluation parameter $FOM = \frac{Q}{\sqrt{C}}$ is defined as a determining criterion for evaluating impact of the structure of the piezoelectric MEMS sensor on a value of the SNR. It can be learned that there is a positive correlation between the value of the SNR of the piezoelectric MEMS sensor and a value of a quantity Q of charges. Further, the quantity Q of charges can be increased, to increase the SNR of the piezoelectric MEMS sensor.

However, if the included angle between the first side face 6011 and the second side face (6012 or 6013) of the cantilever 601 is of an acute-angle structure, the quantity Q of charges generated by the cantilever 601 under the action of the sound signal is reduced. The following describes a reason.

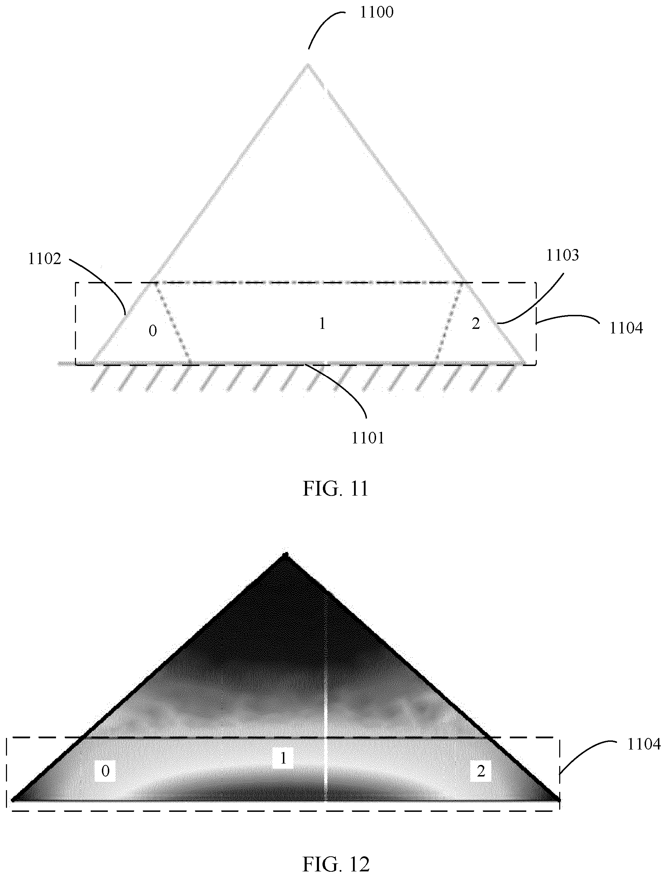

The following description is provided with reference to FIG. 11. As shown in FIG. 11, that an included angle between a first side face 1101 and each of a side face 1102 and a side face 1103 of a cantilever 1100 is of an acute-angle structure is used for description.

A first region 1104 is divided into three sub-regions: a first low stress region 0, a sub-region 1, and a second low stress region 2 in FIG. 11. It can be learned that the first low stress region 0 and the second low stress region 2 are located on two sides of the sub-region 1.

Corresponding voltages are respectively obtained for the first low stress region 0, the sub-region 1, and the second low stress region 2. The first low stress region 0 is used as an example.

A voltage of the first low stress region 0 is $V_0 = \dfrac{Q_0}{C_0} = \dfrac{dQ_0}{\varepsilon A_0}$ . Herein, $Q_0$ is a quantity of charges generated in the first low stress region 0 under the action of the sound signal, $C_0$ is a capacitance value of the first low stress region 0, and d is a thickness of the first region along the axial direction of the sound entry channel 406. The axial direction of the sound entry channel 406 in this application is the direction indicated by the arrow 501 in FIG. 5. Herein, $\varepsilon$ is a dielectric constant of the piezoelectric material, and different sub-regions correspond to a same value of $\varepsilon$. To be specific, the first low stress region 0, the sub-region 1, and the second low stress region 2 correspond to a same value of $\varepsilon$. $A_0$ is an area of the first low stress region 0.

$Q_0 = A_0 d_{31} \delta_0$. Herein, $d_{31}$ is a piezoelectric coefficient of the cantilever 1100 including the first low stress region 0, and $\delta_0$ is stress exerted on the first low stress region 0 under the action of the sound signal.

It can be learned that the voltage of the first low stress region 0 is $V_0 = \dfrac{Q_0}{C_0} = \dfrac{dd_{31}\delta_0}{\varepsilon}$ . By analogy, it can be learned that a voltage of the sub-region 1 is $V_1 = \dfrac{Q_1}{C_1} = \dfrac{dd_{31}\delta_1}{\varepsilon}$ , and a voltage of the second low stress region 2 is $V_2 = \dfrac{Q_2}{C_2} = \dfrac{dd_{31}\delta_2}{\varepsilon}$ .

However, a voltage of the first region 1104 in FIG. 11 is $V = \dfrac{Q}{C} = \dfrac{dd_{31}\delta}{\varepsilon}$ . For a specific description of the first region 1104 in FIG. 11, refer to the foregoing description of the first region 603. Details are not described again. Herein, Q is a quantity of charges generated in the first region 1104 under the action of the sound signal, C is a capacitance value of the first region 1104, and $\delta$ is stress exerted on the first region 1104 under the action of the sound signal.

To better describe a stress distribution in the first region 1104 under the action of the sound signal, refer to FIG. 12. FIG. 12 is a diagram of a simulation of a stress distribution in a first region 1104 of a cantilever under an action of a sound signal. The diagram of the simulation reflects the stress distribution on the cantilever. A region with a darker color bears higher stress.

It can be learned from FIG. 12 that, stress exerted on the first low stress region 0 and the second low stress region 2 that are located at an edge of the first region 1104 is less than stress exerted on the sub-region 1 that is located at a middle location of the first region 1104. In other words, $\delta_0 < \delta_1$ , and $\delta_2 < \delta_1$.

Specifically, the voltage of the first region 1104 in FIG. 11 is $V = V_0 + V_1 + V_2 = \dfrac{dd_{31}\delta_0}{\varepsilon} + \dfrac{dd_{31}\delta_1}{\varepsilon} + \dfrac{dd_{31}\delta_2}{\varepsilon}$. If stress $\delta_0$ exerted on the first low stress region 0 is replaced with stress $\delta_1$ exerted on the sub-region 1, and stress $\delta_2$ exerted on the second low stress region 2 is replaced with stress $\delta_1$ exerted on the sub-region 1, an obtained reference voltage is $V_{\text{Reference voltage}} = V_0 + V_1 + V_2 = \dfrac{dd_{31}\delta_1}{\varepsilon} + \dfrac{dd_{31}\delta_1}{\varepsilon} + \dfrac{dd_{31}\delta_1}{\varepsilon}$ . It can be learned from FIG. 12 that $\delta_0 < \delta_1$ and $\delta_2 < \delta_1$, and therefore, it can be learned that $V < V_{\text{Reference voltage}}$. It can be learned that the first low stress region 0 and the second low stress region 1 play a counteractive effect on a process of increasing the voltage of the first region. To be specific, the first low stress region 0 and the second low stress region 2 contribute only capacitance but do not contribute a charge to the cantilever, and are equivalent to a function of a parasitic capacitor.

It can be learned that, with reference to FIG. 11 and FIG. 12, because the first region 1104 of the cantilever includes a low stress region, the stress distribution in the first region is uneven, and the low stress region plays a counteractive effect on obtaining of a voltage of the cantilever. Specifically, if a voltage of the low stress regions is added in a process of obtaining the voltage of the cantilever, a value of the voltage obtained by the cantilever is reduced, to reduce the SNR and sensitivity of the piezoelectric MEMS sensor.

The following describes a difference between a cantilever including a low stress region and a cantilever including no low stress region in this application:

First, still refer to FIG. 6. It can be learned, through a comparison between FIG. 11 and FIG. 6, that after the foregoing low stress region is removed from the cantilever provided in this embodiment, the included angled between the first side face 6011 of the first region 603 provided in this embodiment and a side face connected to the first side face 6011 in the first region 603 is of a right-angle structure or an obtuse-angle structure. Therefore, the cantilever in this embodiment does not include a low stress region, so that a voltage of a low stress region used as a parasitic capacitor is not obtained in a process in which the cantilever obtains the voltage, to effectively increase the value of the voltage obtained by the cantilever provided in this embodiment under the action of the sound signal.

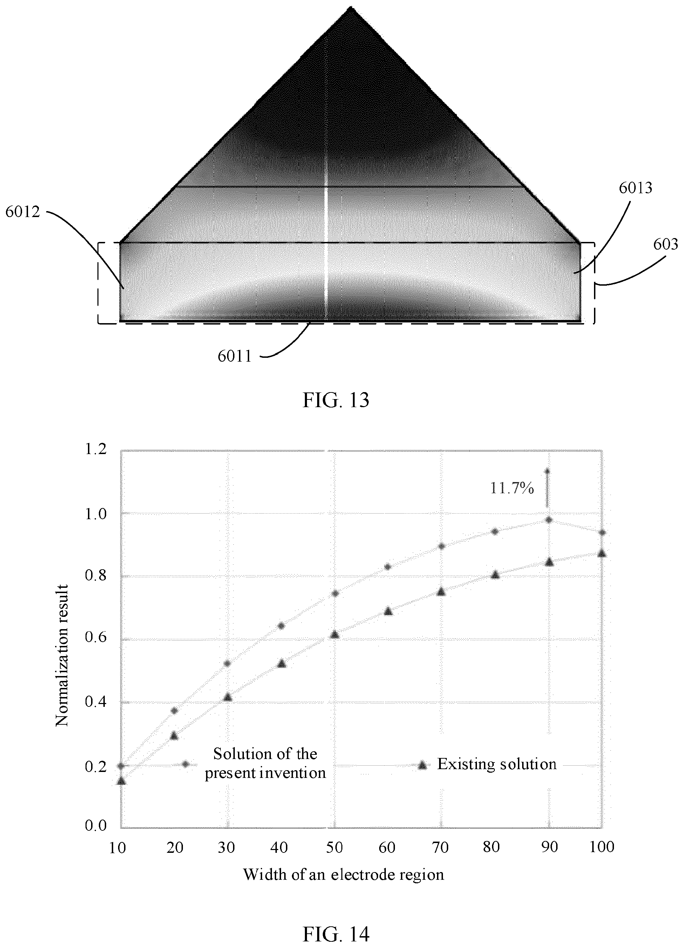

Then, with reference to FIG. 13, it can be learned that FIG. 13 is a diagram of a simulation of a stress distribution in a first region of a cantilever under an action of a sound signal according to this embodiment of this application. A stress distribution in the first region 603 of the cantilever in this embodiment is more even than a stress distribution in the first region shown in FIG. 12, to effectively improve a signal-to-noise ratio and sensitivity of the cantilever provided in this embodiment.

Then, FIG. 14 is an example diagram of a performance comparison between a cantilever including a low stress region and a cantilever including no low stress region in this embodiment. A horizontal coordinate shown in FIG. 14 indicates a width of the electrode region. Specifically, FIG. 6 is used as an example. The width of the electrode region may be h1 in FIG. 6. Normalization parameters obtained by performing normalization processing on FOMs respectively corresponding to widths of all electrode regions included in horizontal coordinates shown in FIG. 14 constitute vertical coordinates shown in FIG. 14. It can be understood that, in a coordinate system shown in FIG. 14, a larger normalization parameter corresponding to a same horizontal coordinate indicates a larger corresponding FOM.

It can be learned from the foregoing description that $FOM = \dfrac{Q}{\sqrt{C}}$ is defined as the determining criteria for evaluating the impact of the structure of the piezoelectric MEMS sensor on the value of the SNR. Still refer to FIG. 14. It can be learned that, that the width of the electrode region is 90 $\mu$m is used as an example. When the width of the electrode region is 90 $\mu$m, a normalization parameter corresponding to the cantilever in the solution of the present invention is 11.7% greater than a normalization parameter in an existing solution (the foregoing solution in which a low stress region is included). It can be learned that the cantilever in the solution of the present invention is used to effectively increase a value of the FOM, to further effectively improve a signal-to-noise ratio and sensitivity of the cantilever.

Optionally, still refer to FIG. 6. Along a radial direction of the sound entry channel 406, an area of the first region 603 is less than or equal to 50% of an area of the cantilever. When the area of the first region 603 is less than or equal to 50% of the area of the cantilever, the signal-to-noise ratio and the sensitivity of the cantilever provided in this embodiment may be effectively improved.

The following describes beneficial effects of the cantilever provided in this embodiment:

It can be learned that, in the structure of the cantilever in this embodiment, because the included angle between the first side face and the side face connected to the first side face in the first region is any angle greater than or equal to 90 degrees and less than 180 degrees, there are fewer restrictions on two sides of the first region of the cantilever in this embodiment, in other words, the two sides of the first region of the cantilever are not constrained by another structure, to effectively ensure free deformation of the cantilever, help improve evenness of the stress distribution on the cantilever, and effectively improve the signal-to-noise ratio and the sensitivity.

The second region of the cantilever in this embodiment may be deformed freely along a direction of the sound entry channel, so that the cantilever in this embodiment can fully release stress, and there is no difficulty in releasing the stress. For piezoelectric MEMS sensors that are produced in batches, because the cantilever can fully release the stress, it can be effectively ensured that same residual stress is obtained after the batch of piezoelectric MEMS sensors release stress, to effectively ensure consistency of the batch of piezoelectric MEMS sensors.

To better understand the structure of the cantilever provided in this embodiment, the following provides an example description of several optional implementations of a shape of the cantilever.

Manner 1

Along the radial direction of the sound entry channel 406 (a direction indicated by an arrow 502 in FIG. 5), the first region 603 is of a quadrate structure, and the second region 604 is of a triangular structure. The quadrate structure may be a rectangular structure, or may be a square structure. This is not specifically limited.

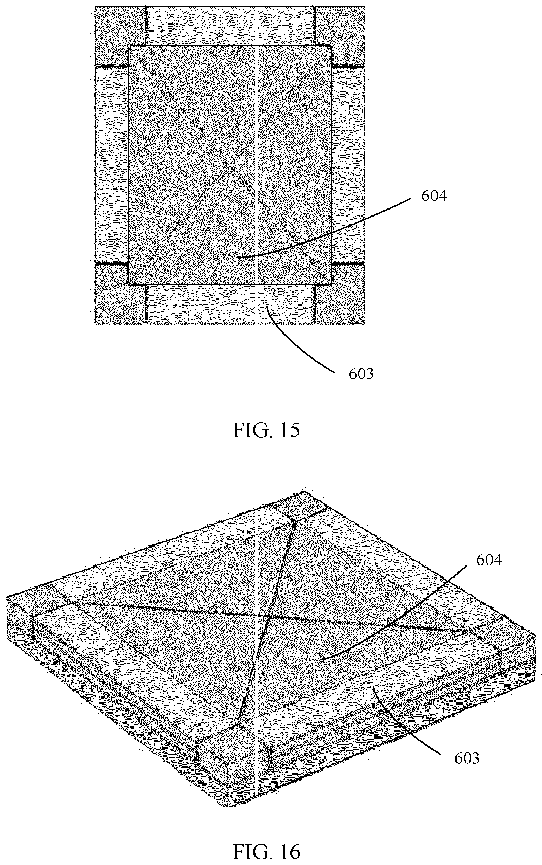

Optionally, as shown in FIG. 6, FIG. 15, and FIG. 16, FIG. 15 is an example diagram of a top-view structure in an embodiment of a piezoelectric MEMS sensor according to an embodiment. FIG. 16 is an example diagram of an overall structure in an embodiment of a piezoelectric MEMS sensor according to an embodiment.

In this embodiment, that the first region 603 is of a rectangular structure is used as an example for an example description. In another example, the first region may also be of a quadrate structure. In this embodiment, that the second region 604 is triangular is used as an example for an example description. If the piezoelectric MEMS sensor includes a plurality of cantilevers, when a second region 604 of each cantilever is triangular, a quantity of cantilevers can be increased as much as possible in a case of a limited area of the sound entry channel 406 of the piezoelectric MEMS sensor, to improve utilization efficiency of the sound entry channel 406, and improve sensitivity of the piezoelectric MEMS sensor.

In the cantilever shown in FIG. 6, a length of a top edge of the first region 603 is equal to a length of a bottom edge of the second region 604. The top edge of the first region 603 is an edge that is of the first region 603 and that is connected to the second region 604 in the cantilever, and the bottom edge of the second region 604 is an edge that is of the second region 604 and that is connected to the first region 603 in the cantilever.

In another optional implementation, the length of the top edge of the first region 603 may alternatively be greater than the length of the bottom edge of the second region 604, or the length of the top edge of the first region 603 may be less than the length of the bottom edge of the second region 604. This is not specifically limited in this embodiment.

It can be learned that, in the structure of the cantilever in this manner, the included angle between the first side face 6011 of the first region and the side face connected to the first side face 6011 in the first region is a right angle.

In addition, electrodes may be attached to the two surfaces of the first region 603. In this embodiment, values and shapes of specific areas of the electrodes attached to the two surfaces of the first region 603 are not limited.

Manner 2

As shown in FIG. 9, FIG. 10, and FIG. 17, along the radial direction of the sound entry channel 406, the first region 603 is of a trapezoidal structure, and the second region 604 is of a triangular structure. When the first region 603 is of a trapezoidal structure, the included angle between the first side face 6011 and the second side face (6012 and/or 6013) connected to the first side face 6011 in the first region shown in this manner is greater than 90 degrees and less than 180 degrees. In other words, in this embodiment, a value of the included angle between the first side face 6011 and the second side face (6012 and/or 6013) connected to the first side face 6011 in the first region is not limited, and it only needs to be ensured that the included angle is of an obtuse-angle structure.

In the cantilever shown in FIG. 17, a length of a top edge of the first region 603 is equal to a length of a bottom edge of the second region 604. For a specific description of the top edge of the first region 603 and the bottom edge of the second region 6014, refer to the description in Manner 1. Details are not described herein again.

In another optional implementation, the length of the top edge of the first region 603 may alternatively be greater than the length of the bottom edge of the second region 604, or the length of the top edge of the first region 603 may be less than the length of the bottom edge of the second region 604. This is not specifically limited in this embodiment.

In the foregoing example, that the top edge of the first region 603 and the bottom edge of the second region 604 in the cantilever each are of a linear structure is used as an example for an example description. In another example, the top edge of the first region 603 and the bottom edge of the second region 604 may alternatively be in any shape such as a curve shape, a fold line shape, or an irregular shape. This is not specifically limited in this embodiment.

In this manner, a degree of freedom of the first region 603 of a trapezoidal structure is further increased, to further improve a stress distribution in the first region 603 of the cantilever, effectively improve evenness of the stress distribution in the first region 603, and improve the sensitivity and the SNR of the piezoelectric MEMS sensor.

The following specifically describes a specific composition structure of a cantilever provided in an embodiment:

First structure of the cantilever:

First, refer to FIG. 18. FIG. 18 is an example diagram of a tangent plane structure of a cantilever according to an embodiment. Specifically, FIG. 18 is an example diagram of a tangent plane structure of a cantilever along an axial direction of a sound entry channel (a direction indicated by an arrow 501 in FIG. 5).

A cantilever 1800 in FIG. 18 includes a piezoelectric film unit 1803. The piezoelectric film unit 1803 includes one or more layers of piezoelectric thin films. The piezoelectric thin film is made of a piezoelectric material, and the piezoelectric material includes but is not limited to aluminum nitride (AlN), aluminum scandium nitride (AlScN), lead zirconium titanate piezoelectric ceramics (PZT), zinc oxide (ZnO), or the like.

A quantity of layers of piezoelectric thin films included in the cantilever 1800 is not limited in this embodiment. To obtain a voltage generated by the cantilever 1800 under an action of a sound signal, a first electrode 1801 and a second electrode 1802 are attached to two surfaces of a first region of the cantilever 1800.

A specific manner is as follows: Along the axial direction of the sound entry channel, the piezoelectric thin film unit includes a first surface and a second surface that are opposite to each other, the first electrode 1801 is attached to the first surface, and the second electrode 1802 is attached to the second surface. For specific descriptions of the first electrode 1801 and the second electrode 1802, refer to the foregoing description. Details are not described herein again.

Optionally, the first electrode 1801 and the second electrode 1802 may be made of a conductive material. The conductive material is not limited in this embodiment. For example, the conductive material may be titanium. To improve a service life of the first electrode 1801 and a service life of the second electrode 1802, an anti-oxidation layer may be disposed on a surface of the first electrode 1801 and a surface of the second electrode 1802, to protect the first electrode 1801 and the second electrode 1802 by using the anti-oxidation layer.

When the cantilever 1800 in this embodiment includes the first electrode 1801 and the second electrode 1802, to obtain the voltage, the piezoelectric thin film unit 1803 in this embodiment wraps a third electrode 1804, and along the axial direction of the sound entry channel, the third electrode 1804 is located between the first electrode 1801 and the second electrode 1802.

Specifically, to obtain the voltage generated by the cantilever under the action of the sound signal, a stress difference needs to be formed between the first surface and the second surface of the cantilever. The following describes how to form the stress difference between the first surface and the second surface of the cantilever:

In the structure shown in FIG. 18, the cantilever is deformed under the action of the sound signal. In order that the first electrode 1801 and the second electrode 1802 can successfully detect the voltage, the piezoelectric thin film unit 1803 may wrap the third electrode 1804 in this embodiment. Therefore, the first electrode 1801 and the third electrode 1804 may obtain a first voltage based on the detected stress difference, the second electrode 1802 and the third electrode 1804 may obtain a second voltage based on detected stress, and an amplification circuit electrically connected to the first electrode 1801, the second electrode 1802, and the third electrode 1804 may obtain the first voltage and the second voltage.

Values of specific areas of the first electrode 1801, the second electrode 1802, and the third electrode 1804 are not limited in this embodiment. It only needs to be ensured that a value of $FOM = \dfrac{Q}{\sqrt{C}}$ of the cantilever including the first electrode 1801, the second electrode 1802, and the third electrode 1804 is as large as possible.

Optionally, the first electrode 1801, the second electrode 1802, and the third electrode 1804 included in the cantilever in this embodiment are disposed in groups. As shown in FIG. 18, that the cantilever includes a group of the first electrode 1801, the second electrode 1802, and the third electrode 1804 is used as an example for an example description. In another example, the cantilever may alternatively include a plurality of groups of the first electrode 1801, the second electrode 1802, and the third electrode 1804, and it only needs to be ensured that each group of the first electrode 1801, the second electrode 1802, and the third electrode 1804 is electrically connected to the amplification circuit.

Second structure of the cantilever:

First, refer to FIG. 19. FIG. 19 is an example diagram of another tangent plane structure of a cantilever according to an embodiment. Specifically, FIG. 19 is an example diagram of a tangent plane structure of a cantilever along an axial direction of a sound entry channel (a direction indicated by an arrow 501 in FIG. 5).

A cantilever 1900 shown in FIG. 19 includes a piezoelectric film unit 1901. For a specific description of the piezoelectric film unit 1901, refer to the foregoing description. Details are not described again. A first electrode 1902 and a second electrode 1903 are disposed in a first region of the cantilever 1900. For specific descriptions of the first electrode 1902 and the second electrode 1903, refer to the foregoing descriptions. Details are not described herein again.

Values of specific areas of the first electrode 1902 and the second electrode 1903 are not limited in this embodiment, and it only needs to be ensured that a value of $FOM = \dfrac{Q}{\sqrt{C}}$ of the cantilever including the first electrode 1902 and the second electrode 1903 is as large as possible.

Specifically, to obtain a voltage generated by the cantilever 1900 under an action of a sound signal, the cantilever 1900 in this embodiment further includes a support layer 1904. The support layer 1901 is attached to a surface that is of the piezoelectric thin film unit and that faces the sound entry channel 406. To connect the cantilever 1900 and a substrate 401, in this manner, an end portion of the support layer 1904 is connected to the substrate 401.

Still refer to FIG. 19. It can be learned that the piezoelectric thin film unit 1901 attached to the support layer 1904 is connected to the substrate 401. In this case, a first side face of the cantilever 1900 is a side face on which the piezoelectric thin film unit 1901 is connected to the substrate 401.

It can be learned from the foregoing that, to obtain the voltage generated by the cantilever under the action of the sound signal, when the cantilever 1900 in this embodiment is deformed, a part of deformation of the second surface of the cantilever 1900 is counteracted under a withstanding action of the support layer 1901, to form a stress difference between stress generated on the first surface of the cantilever 1900 and stress generated on the second surface. The first electrode 1902 and the second electrode 1903 may obtain the voltage based on the stress difference.

In the structure shown in this manner, the cantilever 1900 is connected to the substrate 401 by using the support layer 1904, to reduce rigidity of an end portion that is of the cantilever and that is connected to the substrate. Therefore, there is a smaller device dimension in a case of a same frequency, to help miniaturize a piezoelectric MEMS sensor.

Third structure of the cantilever:

FIG. 20 is an example diagram of another tangent plane structure of a cantilever according to an embodiment. Specifically, FIG. 20 is an example diagram of a tangent plane structure of a cantilever along an axial direction of a sound entry channel (a direction indicated by an arrow 501 in FIG. 5).

A cantilever 2000 shown in FIG. 20 includes a piezoelectric film unit 2001. For a specific description of the piezoelectric film unit 2001, refer to the foregoing description. Details are not described again. A first electrode 2000 and a second electrode 2002 are attached to a first region of the cantilever 2003. For specific descriptions of the first electrode 2002 and the second electrode 2003, refer to the foregoing descriptions. Details are not described herein again. The cantilever 2000 shown in this manner further includes a support layer 2004. For a specific description of the support layer 2004, refer to the foregoing description. Details are not described herein again.

In this manner, there is a gap 2005 between a piezoelectric thin film unit 2001 and a substrate 401. A specific size of the gap 2005 is not limited in this embodiment. In this case, a first side face of the cantilever 100 is a side face that is of the piezoelectric thin film unit 2001 and that faces a target face 500.

It can be learned from the foregoing that, to obtain the voltage generated by the cantilever under an action of a sound signal, a stress difference needs to be generated between a first surface and a second surface of the cantilever, and the first electrode 2002 and the second electrode 2003 may obtain the voltage based on the stress difference. In the structure shown in FIG. 20, the cantilever 2000 is deformed under the action of the sound signal, and stress generated on the first surface of the cantilever 2000 and stress generated on the second surface of the cantilever 2000 counteract each other. Consequently, the first electrode 2002 and the second electrode 2003 cannot successfully detect the voltage. Therefore, when the cantilever 2000 in this embodiment is deformed, a part of deformation of the second surface of the cantilever 2000 is counteracted under a withstanding action of the support layer 2001, to form a stress difference between the stress generated on the first surface of the cantilever 2000 and stress generated on the second surface. The first electrode 2002 and the second electrode 2003 may obtain the voltage based on the stress difference.

Optionally, in the foregoing embodiment. that a piezoelectric MEMS sensor includes one layer of cantilevers along the axial direction of the sound entry channel is used as an example for an example description. In this case, a plurality of cantilevers are electrically connected to an amplification circuit through parallel coupling, to effectively improve a value of output capacitance of the piezoelectric MEMS sensor. Optionally, the piezoelectric MEMS sensor may alternatively include a plurality of layers of cantilevers. To be specific, two or more cantilevers are disposed in a stacked manner along the axial direction of the sound entry channel, and the plurality of cantilevers disposed in the stacked manner are electrically connected to the amplification circuit through series coupling, to effectively increase a value of an output voltage of the piezoelectric MEMS sensor.

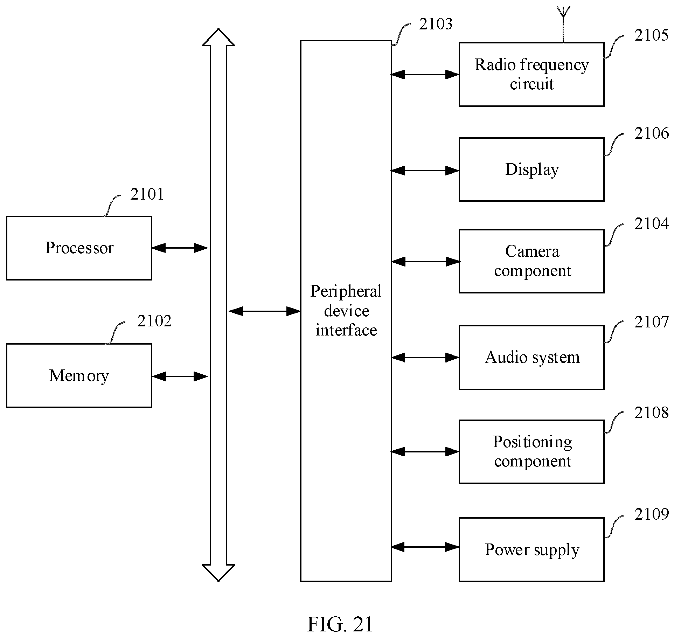

An embodiment of this application provides a terminal device, including the piezoelectric MEMS microphone provided in the foregoing embodiments of this application. FIG. 21 is a block diagram of a structure of a terminal device according to an example embodiment of this application. The terminal device may be a device integrated with an audio function, for example, a smartphone, a tablet computer, an intelligent robot, or a notebook computer, or may be transportation such as a vehicle with a voice recognition function. The terminal device may also be referred to as user equipment, a portable terminal, a laptop terminal, a desktop terminal, a vehicle-mounted terminal, or the like.

Usually, the terminal device further includes a processor 2101 and a memory 2102.

The processor 2101 may include one or more processing cores, for example, the processor 2101 may be a 4-core processor or an 8-core processor. The processor 2101 may be implemented in at least one hardware form of a digital signal processor (DSP), an FPGA, and a programmable logic array (PLA). The processor 2101 may further include a main processor and a coprocessor. The main processor is a processor configured to process data in a wake-up state, and is also referred to as a central processing unit (CPU). The coprocessor is a low power consumption processor configured to process data in a standby state. In some embodiments, the processor 2101 may be integrated with an image processor (GPU), and the GPU is configured to be responsible for rendering and drawing of content that needs to be displayed on a display. In some embodiments, the processor 2101 may further include an artificial intelligence (AI) processor, and the AI processor is configured to process a computing operation related to machine learning.

The memory 2102 may include one or more computer-readable storage media, where the computer-readable storage medium may be in a non-transient state. The memory 2102 may further include a high-speed random access memory and a non-volatile memory, for example, one or more magnetic disk storage devices or flash memory storage devices. In some embodiments, the non-transient computer-readable storage medium in the memory 2102 is configured to store at least one instruction.

In some embodiments, the terminal device may further optionally include a peripheral device interface 2103 and at least one peripheral device. The processor 2101, the memory 2102, and the peripheral device interface 2103 may be connected through a bus or a signal line. Each peripheral device may be connected to the peripheral device interface 2103 through the bus, the signal line, or by using a circuit board. Specifically, the peripheral device includes at least one of a camera component 2104, a radio frequency circuit 2105, a display 2106, an audio system 2107, a positioning component 2108, and a power supply 2109.

The peripheral device interface 2103 may be configured to connect at least one input/output (I/O)-related peripheral device and each of the processor 2101 and the memory 2102. In some embodiments, the processor 2101, the memory 2102, and the peripheral device interface 2103 are integrated on a same chip or circuit board. In some other embodiments, any one or two of the processor 2101, the memory 2102, and the peripheral device interface 2103 may be implemented on a separate chip or circuit board. This is not limited in this embodiment.

The camera component 2104 is configured to: collect an image or a video, and send collected image or video information to the processor 2101, to perform image preview processing or storage. In some embodiments, the camera component 2104 may further include a flash.

The radio frequency circuit 2105 is configured to receive and transmit a radio frequency (RF) signal, which is also referred to as an electromagnetic signal. The radio frequency circuit 2105 communicates with a communication network and another communication device by using the electromagnetic signal. The radio frequency circuit 2105 converts an electrical signal into an electromagnetic signal for transmission, or converts a received electromagnetic signal into an electrical signal.

The display 2106 is configured to display a user interface (UI). The UI may include a graph, a text, an icon, a video, and any combination thereof.

The audio system 2107 may include the piezoelectric MEMS microphone (as shown in FIG. 4 or FIG. 5) and an audio circuit that are provided in embodiments of this application. The piezoelectric MEMS microphone is configured to: collect a sound wave of a user and an environment, convert the sound wave into a voltage, and send a voltage value to the audio circuit. The audio circuit is configured to convert the voltage value into an electrical signal, and may input the electrical signal into the processor 2101 for processing, or input the electrical signal into the radio frequency circuit 2105 to implement voice communication. For purposes of stereo collection or noise reduction, there may be a plurality of microphones. The microphones are respectively disposed at different parts of a terminal device. In some embodiments, the audio system 2107 may further include a headset jack and a speaker.

The positioning component 2108 is configured to locate a current geographic location of the terminal device, to implement navigation or location based service (LBS).

The power supply 2109 is configured to supply power to each component in the terminal device.

A person skilled in the art may understand that the structure shown in FIG. 21 does not constitute a limitation on the terminal device, and the terminal device may include more or fewer components than those shown in the figure, or combine some components, or use different types of component arrangement.

It should be noted that, for clarity of the descriptions of embodiments of this application, unrelated components may not be shown in the reference accompanying drawings, and for clarity, thicknesses of the layers and the areas may be exaggerated. Although an example of a parameter including a particular value is provided in embodiments of this application, it should be understood that the parameter does not need to be exactly equal to a corresponding value, but may be approximated to the corresponding value within an accepted error tolerance or a design constraint.

**Claims**

1. A piezoelectric MEMS sensor (405), comprising a substrate (401) and at least one cantilever (601, 1100, 1800, 1900, 2000), wherein the substrate (401) comprises a sound entry channel (406), the cantilever (601, 1100, 1800, 1900, 2000) comprises a first region (603, 1104) and a second region (604) that are connected to each other, the second region (604) is suspended over a channel port of the sound entry channel (406), the first region (603, 1104) is located between the second region (604) and the substrate (401), and an area of the second region (604) gradually decreases in a direction away from the first region (603, 1104); and the cantilever (601, 1100, 1800, 1900, 2000) is configured to obtain a corresponding voltage under an action of a sound signal (302) that deforms the cantilever, wherein the sound signal (302) is transmitted through the sound entry channel (406), and
the first region (603, 1104) comprises a first side face (1101, 6011) and a second side face (1102, 1103, 6012, 6013) connected to the first side face (1101, 6011), the first side face (1101, 6011) is a side face that is of the first region (603, 1104) and that faces a target face (500), the target face (500) is a face that is of the cantilever (601, 1100, 1800, 1900, 2000) and that is connected to the substrate (401), and an included angle between the first side face (1101, 6011) and the second side face (1102, 1103, 6012, 6013) is greater than or equal to 90 degrees and less than 180 degrees.

2. The piezoelectric MEMS sensor (405) according to claim 1, wherein perpendicular to an axial direction of the sound entry channel (406), the first region (603, 1104) is of a quadrate structure, and the second region (604) is of a triangular structure.

3. The piezoelectric MEMS sensor (405) according to claim 1, wherein perpendicular to an axial direction of the sound entry channel (406), the first region (603, 1104) is of a trapezoidal structure, the second region (604) is of a triangular structure, and the included angle between the first side face (1101, 6011) and the second side face (1102, 1103, 6012, 6013) is greater than 90 degrees and less than 180 degrees.

4. The piezoelectric MEMS sensor (405) according to claim 2 or 3, wherein the cantilever (601, 1100, 1800, 1900, 2000) further comprises a first electrode (605, 1801, 1902, 2002) and a second electrode (606, 1802, 1903, 2003); and the first region (603, 1104) comprises a piezoelectric thin film unit (1803, 1901, 2001); and along the axial direction of the sound entry channel (406), the piezoelectric thin film unit (1803, 1901, 2001) comprises a first surface and a second surface that are opposite to each other, the first electrode (605, 1801, 1902, 2002) is located on the first surface, the second electrode (606, 1802, 1903, 2003) is located on the second surface, the first electrode (605, 1801, 1902, 2002) and the second electrode (606, 1802, 1903, 2003) are configured to obtain the voltage, and the piezoelectric thin film unit (1803, 1901, 2001) comprises at least one layer of piezoelectric thin film.

5. The piezoelectric MEMS sensor (405) according to claim 4, wherein the piezoelectric thin film unit (1803) wraps a third electrode (1804), and the third electrode (1804) is located between the first electrode (1801) and the second electrode (1802) along the axial direction of the sound entry channel (406).

6. The piezoelectric MEMS sensor (405) according to claim 4, wherein the cantilever (1900, 2000) further comprises a support layer (1904, 2004), the support layer (1904, 2004) is attached to a surface that is of the piezoelectric thin film unit (1901, 2001) and that faces the sound entry channel (406), and an end portion of the support layer (1904, 2004) is connected to the substrate (401).

7. The piezoelectric MEMS sensor (405) according to claim 6, wherein the piezoelectric thin film unit (1803, 1901) is connected to the substrate (401), and the first side face (1101, 6011) is a side face on which the piezoelectric thin film unit (1803, 1901) is connected to the substrate (401).

8. The piezoelectric MEMS sensor (405) according to claim 6, wherein there is a gap between the piezoelectric thin film unit (2001) and the substrate (401), and the first side face (1101, 6011) is a side face that is of the piezoelectric thin film unit (2001) and that faces the target face (500).

9. The piezoelectric MEMS sensor (405) according to any one of claims 1 to 8, wherein along a radial direction of the sound entry channel (406), an area of the first region (603, 1104) is less than or equal to 50% of an area of the cantilever (601, 1100, 1800, 1900, 2000).

10. The piezoelectric MEMS sensor (405) according to any one of claims 1 to 9, wherein the piezoelectric MEMS sensor (405) comprises four cantilevers (601, 1100, 1800, 1900, 2000), and there is a gap (602) between any two adjacent cantilevers (601, 1100, 1800, 1900, 2000).

11. The piezoelectric MEMS sensor (405) according to any one of claims 1 to 10, wherein the first region (603, 1104) comprises two second side faces (1102, 1103, 6012, 6013).

12. A piezoelectric MEMS microphone (301, 400), comprising an amplification circuit (404) and a piezoelectric MEMS sensor (405) according to any one of claims 1 to 11, wherein the piezoelectric MEMS sensor (405) and the amplification circuit (404) are electrically connected, the piezoelectric MEMS sensor (405) is configured to obtain a voltage under an action of a sound signal (302) that deforms the cantilever of the piezoelectric MEMS sensor, and the amplification circuit (404) is configured to obtain and amplify the voltage.

13. A terminal device, comprising an audio system (300), wherein the audio system (300) comprises one or more piezoelectric MEMS microphones (301, 400), and an audio circuit (303) electrically connected to the piezoelectric MEMS microphone (301, 400), and the piezoelectric MEMS microphone (301, 400) is shown in claim 12.

**Patentansprüche**

1. Piezoelektrischer MEMS-Sensor (405), umfassend ein Substrat (401) und mindestens einen Ausleger (601, 1100, 1800, 1900, 2000), wobei das Substrat (401) einen Schalleingangskanal (406) umfasst, der Ausleger (601, 1100, 1800, 1900, 2000) eine erste Region (603, 1104) und eine zweite Region (604) umfasst, die miteinander verbunden sind, die zweite Region (604) über einem Kanalanschluss des Schalleingangskanals (406) aufgehängt ist, sich die erste Region (603, 1104) zwischen der zweiten Region (604) und dem Substrat (401) befindet und sich ein Bereich der zweiten Region (604) in einer Richtung von der ersten Region (603, 1104) weg allmählich verringert; und der Ausleger (601, 1100, 1800, 1900, 2000) dazu konfiguriert ist, unter einer Einwirkung eines Schallsignals (302), das den Ausleger verformt, eine entsprechende Spannung zu erlangen, wobei das Schallsignal (302) über den Schalleingangskanal (406) übertragen wird, und die erste Region (603, 1104) eine erste Seitenfläche (1101, 6011) und eine zweite Seitenfläche (1102, 1103, 6012, 6013), die mit der ersten Seitenfläche (1101, 6011) verbunden ist, umfasst, die erste Seitenfläche (1101, 6011) eine Seitenfläche ist, die der ersten Region (603, 1104) angehört und die einer Zielfläche (500) zugewandt ist, die Zielfläche (500) eine Fläche ist, die dem Ausleger (601, 1100, 1800, 1900, 2000) angehört und die mit dem Substrat (401) verbunden ist, und ein eingeschlossener Winkel zwischen der ersten Seitenfläche (1101, 6011) und der zweiten Seitenfläche (1102, 1103, 6012, 6013) größer als oder gleich 90 Grad und kleiner als 180 Grad ist.

2. Piezoelektrischer MEMS-Sensor (405) nach Anspruch 1, wobei senkrecht zu einer axialen Richtung des Schalleingangskanals (406) die erste Region (603, 1104) eine quadratische Struktur aufweist und die zweite Region (604) eine dreieckige Struktur aufweist.

3. Piezoelektrischer MEMS-Sensor (405) nach Anspruch 1, wobei senkrecht zu einer axialen Richtung des Schalleingangskanals (406) die erste Region (603, 1104) eine trapezförmige Struktur aufweist, die zweite Region (604) eine dreieckige Struktur aufweist und der eingeschlossene Winkel zwischen der ersten Seitenfläche (1101, 6011) und der zweiten Seitenfläche (1102, 1103, 6012, 6013) größer als 90 Grad und kleiner als 180 Grad ist.

4. Piezoelektrischer MEMS-Sensor (405) nach Anspruch 2 oder 3, wobei der Ausleger (601, 1100, 1800, 1900, 2000) ferner eine erste Elektrode (605, 1801, 1902, 2002) und eine zweite Elektrode (606, 1802, 1903, 2003) umfasst; und die erste Region (603, 1104) eine piezoelektrische Dünnfilmeinheit (1803, 1901, 2001) umfasst; und entlang der axialen Richtung des Schalleingangskanals (406) die piezoelektrische Dünnfilmeinheit (1803, 1901, 2001) eine erste Oberfläche und eine zweite Oberfläche umfasst, die einander gegenüberliegen, sich die erste Elektrode (605, 1801, 1902, 2002) auf der ersten Oberfläche befindet, sich die zweite Elektrode (606, 1802, 1903, 2003) auf der zweiten Oberfläche befindet, die erste Elektrode (605, 1801, 1902, 2002) und die zweite Elektrode (606, 1802, 1903, 2003) dazu konfiguriert sind, die Spannung zu erlangen, und die piezoelektrische Dünnfilmeinheit (1803, 1901, 2001) mindestens eine Schicht piezoelektrischen Dünnfilms umfasst.

5. Piezoelektrischer MEMS-Sensor (405) nach Anspruch 4, wobei die piezoelektrische Dünnfilmeinheit (1803) eine dritte Elektrode (1804) umschließt und sich die dritte Elektrode (1804) zwischen der ersten Elektrode (1801) und der zweiten Elektrode (1802) entlang der axialen Richtung des Schalleingangskanals (406) befindet.

6. Piezoelektrischer MEMS-Sensor (405) nach Anspruch 4, wobei der Ausleger (1900, 2000) ferner eine Trägerschicht (1904, 2004) umfasst, die Trägerschicht (1904, 2004) an einer Oberfläche befestigt ist, die der piezoelektrischen Dünnfilmeinheit (1901, 2001) angehört und die dem Schalleingangskanal (406) zugewandt ist, und ein Endabschnitt der Trägerschicht (1904, 2004) mit dem Substrat (401) verbunden ist.

7. Piezoelektrischer MEMS-Sensor (405) nach Anspruch 6, wobei die piezoelektrische Dünnfilmeinheit (1803, 1901) mit dem Substrat (401) verbunden ist und die erste Seitenfläche (1101, 6011) eine Seitenfläche ist, auf der die piezoelektrische Dünnfilmeinheit (1803, 1901) mit dem Substrat (401) verbunden ist.

8. Piezoelektrischer MEMS-Sensor (405) nach Anspruch 6, wobei es zwischen der piezoelektrischen Dünnfilmeinheit (2001) und dem Substrat (401) einen Spalt gibt und die erste Seitenfläche (1101, 6011) eine Seitenfläche ist, die der piezoelektrischen Dünnfilmeinheit (2001) angehört und die der Zielfläche (500) zugewandt ist.

9. Piezoelektrischer MEMS-Sensor (405) nach einem der Ansprüche 1 bis 8, wobei entlang einer radialen Richtung des Schalleingangskanals (406) ein Bereich der ersten Region (603, 1104) kleiner als oder gleich 50 % eines Bereichs des Auslegers (601, 1100, 1800, 1900, 2000) ist.

**10.** Piezoelektrischer MEMS-Sensor (405) nach einem der Ansprüche 1 bis 9, wobei der piezoelektrische MEMS-Sensor (405) vier Ausleger (601, 1100, 1800, 1900, 2000) umfasst und es zwischen zwei beliebigen benachbarten Auslegern (601, 1100, 1800, 1900, 2000) einen Spalt (602) gibt.

**11.** Piezoelektrischer MEMS-Sensor (405) nach einem der Ansprüche 1 bis 10, wobei die erste Region (603, 1104) zwei zweite Seitenflächen (1102, 1103, 6012, 6013) umfasst.

**12.** Piezoelektrisches MEMS-Mikrofon (301, 400), umfassend eine Verstärkerschaltung (404) und einen piezoelektrischen MEMS-Sensor (405) nach einem der Ansprüche 1 bis 11, wobei der piezoelektrische MEMS-Sensor (405) und die Verstärkerschaltung (404) elektrisch verbunden sind, der piezoelektrische MEMS-Sensor (405) dazu konfiguriert ist, unter einer Einwirkung eines Schallsignals (302), das den Ausleger des piezoelektrischen MEMS-Sensors verformt, eine Spannung zu erlangen, und die Verstärkerschaltung (404) dazu konfiguriert ist, die Spannung zu erlangen und zu verstärken.

**13.** Endgerätevorrichtung, umfassend ein Audiosystem (300), wobei das Audiosystem (300) ein oder mehrere piezoelektrische MEMS-Mikrofone (301, 400) und eine Audioschaltung (303) umfasst, die elektrisch mit dem piezoelektrischen MEMS-Mikrofon (301, 400) verbunden ist, und das piezoelektrische MEMS-Mikrofon (301, 400) in Anspruch 12 gezeigt ist.

**Revendications**

**1.** Capteur MEMS piézoélectrique (405), comprenant un substrat (401) et au moins un cantilever (601, 1100, 1800, 1900, 2000), dans lequel le substrat (401) comprend un canal d'entrée sonore (406), le cantilever (601, 1100, 1800, 1900, 2000) comprend une première région (603, 1104) et une seconde région (604) qui sont connectées l'une à l'autre, la seconde région (604) est suspendue au-dessus d'un port de canal du canal d'entrée sonore (406), la première région (603, 1104) est située entre la seconde région (604) et le substrat (401), et une zone de la seconde région (604) diminue progressivement dans une direction s'éloignant de la première région (603, 1104) ; et le cantilever (601, 1100, 1800, 1900, 2000) est configuré pour obtenir une tension correspondante sous l'action d'un signal sonore (302) qui déforme le cantilever, dans lequel le signal sonore (302) est transmis par le biais du canal d'entrée sonore (406), et la première région (603, 1104) comprend une première face latérale (1101, 6011) et une seconde face latérale (1102, 1103, 6012, 6013) connectée à la première face latérale (1101, 6011), la première face latérale (1101, 6011) est une face latérale qui est de la première région (603, 1104) et qui fait face à une face cible (500), la face cible (500) est une face qui est du cantilever (601, 1100, 1800, 1900, 2000) et qui est connectée au substrat (401), et un angle inclus entre la première face latérale (1101, 6011) et la seconde face latérale (1102, 1103, 6012, 6013) est supérieur ou égal à 90 degrés et inférieur à 180 degrés.

**2.** Capteur MEMS piézoélectrique (405) selon la revendication 1, dans lequel, perpendiculairement à une direction axiale du canal d'entrée sonore (406), la première région (603, 1104) est de structure carrée et la seconde région (604) est de structure triangulaire.

**3.** Capteur MEMS piézoélectrique (405) selon la revendication 1, dans lequel, perpendiculairement à une direction axiale du canal d'entrée sonore (406), la première région (603, 1104) est de structure trapézoïdale, la seconde région (604) est de structure triangulaire, et l'angle inclus entre la première face latérale (1101, 6011) et la seconde face latérale (1102, 1103, 6012, 6013) est supérieur à 90 degrés et inférieur à 180 degrés.

**4.** Capteur MEMS piézoélectrique (405) selon la revendication 2 ou 3, dans lequel le cantilever (601, 1100, 1800, 1900, 2000) comprend également une première électrode (605, 1801, 1902, 2002) et une deuxième électrode (606, 1802, 1903, 2003) ; et la première région (603, 1104) comprend une unité de film mince piézoélectrique (1803, 1901, 2001) ; et le long de la direction axiale du canal d'entrée sonore (406), l'unité de film mince piézoélectrique (1803, 1901, 2001) comprend une première surface et une seconde surface qui sont opposées l'une à l'autre, la première électrode (605, 1801, 1902, 2002) est située sur la première surface, la deuxième électrode (606, 1802, 1903, 2003) est située sur la seconde surface, la première électrode (605, 1801, 1902, 2002) et la deuxième électrode (606, 1802, 1903, 2003) sont configurées pour obtenir la tension, et l'unité de film mince piézoélectrique (1803, 1901, 2001) comprend au moins une couche de film mince piézoélectrique.

**5.** Capteur MEMS piézoélectrique (405) selon la revendication 4, dans lequel l'unité de film mince piézoélectrique (1803) enveloppe une troisième électrode (1804), et la troisième électrode (1804) est située entre la première électrode (1801) et la deuxième électrode (1802) le long de la direction axiale du canal d'entrée sonore (406).

6. Capteur MEMS piézoélectrique (405) selon la revendication 4, dans lequel le cantilever (1900, 2000) comprend également une couche de support (1904, 2004), la couche de support (1904, 2004) est fixée à une surface qui est de l'unité de film mince piézoélectrique (1901, 2001) et qui fait face au canal d'entrée sonore (406), et une partie d'extrémité de la couche de support (1904, 2004) est connectée au substrat (401).

7. Capteur MEMS piézoélectrique (405) selon la revendication 6, dans lequel l'unité de film mince piézoélectrique (1803, 1901) est connectée au substrat (401), et la première face latérale (1101, 6011) est une face latérale sur laquelle l'unité de film mince piézoélectrique (1803, 1901) est connectée au substrat (401).

8. Capteur MEMS piézoélectrique (405) selon la revendication 6, dans lequel il existe un espace entre l'unité de film mince piézoélectrique (2001) et le substrat (401), et la première face latérale (1101, 6011) est une face latérale qui est de l'unité de film mince piézoélectrique (2001) et qui fait face à la face cible (500).

9. Capteur MEMS piézoélectrique (405) selon l'une quelconque des revendications 1 à 8, dans lequel, le long d'une direction radiale du canal d'entrée sonore (406), une zone de la première région (603, 1104) est inférieure ou égale à 50 % d'une zone du cantilever (601, 1100, 1800, 1900, 2000).

10. Capteur MEMS piézoélectrique (405) selon l'une quelconque des revendications 1 à 9, dans lequel le capteur MEMS piézoélectrique (405) comprend quatre cantilevers (601, 1100, 1800, 1900, 2000), et il existe un espace (602) entre deux cantilevers adjacents quelconques (601, 1100, 1800, 1900, 2000).

11. Capteur MEMS piézoélectrique (405) selon l'une quelconque des revendications 1 à 10, dans lequel la première région (603, 1104) comprend deux secondes faces latérales (1102, 1103, 6012, 6013).

12. Microphone MEMS piézoélectrique (301, 400), comprenant un circuit d'amplification (404) et un capteur MEMS piézoélectrique (405) selon l'une quelconque des revendications 1 à 11, dans lequel le capteur MEMS piézoélectrique (405) et le circuit d'amplification (404) sont connectés électriquement, le capteur MEMS piézoélectrique (405) est configuré pour obtenir une tension sous l'action d'un signal sonore (302) qui déforme le cantilever du capteur MEMS piézoélectrique, et le circuit d'amplification (404) est configuré pour obtenir et amplifier la tension.

13. Dispositif terminal, comprenant un système audio (300), dans lequel le système audio (300) comprend un ou plusieurs microphones MEMS piézoélectriques (301, 400), et un circuit audio (303) connecté électriquement au microphone MEMS piézoélectrique (301, 400), et le microphone MEMS piézoélectrique (301, 400) est représenté dans la revendication 12.

FIG. 1

FIG. 2

FIG. 3

FIG. 4

FIG. 5

FIG. 6

601

605

603

606

## FIG. 7

601

No sound

## FIG. 8a

601

Sound pressure signal

## FIG. 8b

FIG. 9

FIG. 10

FIG. 11

FIG. 12

6013

6012

603

6011

FIG. 13

FIG. 14

FIG. 15

FIG. 16

FIG. 17

FIG. 18

FIG. 19

FIG. 20

FIG. 21

**EP 4 037 335 B1**

**Patent documents cited in the description**

- CN 109587612 A
- WO 2018035486 A1
- CN 103460721 A